# EUROPEAN PATENT APPLICATION

(11) **EP 4 626 182 A1**
(43) Date of publication of application: **01.10.2025**
(21) Application number: 25731181.1
(22) Date of filing: 09.01.2025
(51) Int. Cl.: H10F 10/14

(54) **SOLAR CELL AND MANUFACTURING METHOD THEREFOR**

(30) Priority: 23.01.2024 CN 202410092536; 20.02.2024 CN 202410190935; 16.07.2024 CN 202410961507; 03.09.2024 CN 202411231370; 16.08.2024 CN 202411132114; 16.08.2024 CN 202411131776; 03.09.2024 CN 202411231916; 03.09.2024 CN 202411231906; 03.09.2024 CN 202411230518
(71) Applicant: LONGi Green Energy Technology Co., Ltd., Xi'an, Shaanxi 710100 (CN)
(72) Inventor: YU, Mingzhe, Shaanxi 710100 (CN); SUN, Zhaoqing, Shaanxi 710100 (CN); HUANG, Zhipeng, Shaanxi 710100 (CN); TANG, Xiyan, Shaanxi 710100 (CN); DENG, Xiaoyu, Shaanxi 710100 (CN); QIUm Haoran, Shaanxi 710100 (CN); WU, Hua, Shaanxi 710100 (CN); CAO, Yujia, Shaanxi 710100 (CN); FANG, Liang, Shaanxi 710100 (CN); XU, Xixiang, Shaanxi 710100 (CN)
(74) Representative: Grünecker Patent- und Rechtsanwälte PartG mbB
(86) International application number: PCT/CN2025/071598
(87) International publication number: WO 2025/157020

(57) **Abstract**

The present application provides a solar cell and a manufacturing method therefor, and pertains to the field of semiconductor device technologies. The solar cell includes a silicon substrate and a semiconductor layer. The silicon substrate includes a first surface and a second surface that are opposite to each other. The semiconductor layer is located on the first surface. The first semiconductor layer includes a second structural region and a first structural region. A crystallization degree of the first structural region is higher than a crystallization degree of the second structural region. The second structural region is closer to the first surface than the first structural region. The first semiconductor layer includes at least one of amorphous silicon, nanocrystalline silicon, or microcrystalline silicon. The semiconductor layer in the present application has a crystalline structure. This can reduce a contact resistance between the semiconductor layer and a conductive material layer, so that a current transmission characteristic is improved, energy consumption in a current collection process is reduced, and efficiency of the solar cell is improved.

## Description

### CROSS-REFERENCE TO RELATED APPLICATIONS

The present application claims priorities to Chinese Patent Application No. 202410092536.4, filed with the China National Intellectual Property Administration on January 23, 2024 and entitled "SOLAR CELL AND MANUFACTURING METHOD THEREFOR, AND SOLAR MODULE", to Chinese Patent Application No. 202410190935.4, filed with the China National Intellectual Property Administration on February 20, 2024 and entitled "SOLAR CELL AND MANUFACTURING METHOD THEREFOR, AND SOLAR MODULE", to Chinese Patent Application No. 202410961507.7, filed with the China National Intellectual Property Administration on July 16, 2024 and entitled "SOLAR CELL AND MANUFACTURING METHOD THEREFOR", to Chinese Patent Application No. 202411131776.7, filed with the China National Intellectual Property Administration on August 16, 2024 and entitled "SOLAR CELL AND MANUFACTURING METHOD THEREFOR", to Chinese Patent Application No. 202411132114.1, filed with the China National Intellectual Property Administration on August 16, 2024 and entitled "SOLAR CELL AND MANUFACTURING METHOD THEREFOR", to Chinese Patent Application No. 202411231370.6, filed with the China National Intellectual Property Administration on September 3, 2024 and entitled "SOLAR CELL AND MANUFACTURING METHOD THEREFOR", to Chinese Patent Application No. 202411231916.8, filed with the China National Intellectual Property Administration on September 3, 2024 and entitled "SOLAR CELL AND MANUFACTURING METHOD THEREFOR", to Chinese Patent Application No. 202411231906.4, filed with the China National Intellectual Property Administration on September 3, 2024 and entitled "SOLAR CELL AND MANUFACTURING METHOD THEREFOR", and to Chinese Patent Application No. 202411230518.4, filed with the China National Intellectual Property Administration on September 3, 2024 and entitled "SOLAR CELL AND MANUFACTURING METHOD THEREFOR", all of which are incorporated herein by reference in their entireties.

### TECHNICAL FIELD

The present application relates to the field of semiconductor device technologies. Specifically, the present application relates to a solar cell and a manufacturing method therefor.

### BACKGROUND

A heterojunction solar cell has advantages such as high conversion efficiency and a simple process structure. In a conventional heterojunction solar cell, an intrinsic amorphous silicon layer is deposited on two sides of a silicon substrate; then doped amorphous silicon film layers of different doping types are deposited; subsequently, a transparent conductive film layer is prepared on the doped amorphous silicon film layer; and finally, a surface of the transparent conductive film layer is metalized to obtain a metal electrode.

A current transmission resistance has large impact on performance of the heterojunction solar cell. To reduce the current transmission resistance and improve output performance of the solar cell, a contact structure between the metal electrode and the transparent conductive film layer may be improved. For example, seed layers are formed on surfaces of the metal electrode and the transparent conductive film layer to improve adherence, or a new material such as an alloy is used as a material of the metal electrode. However, the current transmission resistance still further needs to be reduced.

### SUMMARY

In view of this, to at least partially resolve at least one of the foregoing technical problems, the present application provides a solar cell and a manufacturing method therefor.

To achieve the foregoing objective, the present application provides the following technical solutions.

According to an embodiment of one aspect of the present application, a solar cell is provided, including: a silicon substrate including a first surface and a second surface that are opposite to each other; and a first semiconductor layer located on the first surface of the silicon substrate, the first semiconductor layer including a second structural region and a first structural region, a crystallization degree of the first structural region being higher than a crystallization degree of the second structural region, the second structural region being closer to the first surface than the first structural region, and the first semiconductor layer including at least one of amorphous silicon, nanocrystalline silicon, or microcrystalline silicon.

According to an embodiment of another aspect of the present application, a manufacturing method for a solar cell is provided, including: forming a semiconductor layer on a silicon substrate, a material of the semiconductor layer including at least one of amorphous silicon, nanocrystalline silicon, or microcrystalline silicon; and processing the semiconductor layer by using a first laser, to increase a crystallization degree of at least a part of the semiconductor layer to form a crystallization zone, the semiconductor layer located in the crystallization zone including a second structural region and a first structural region, a crystallization degree of the first structural region being higher than a crystallization degree of the second structural region, and the second structural region being closer to a first surface than the first structural region.

According to the embodiments of the present application, the semiconductor layer of the solar cell provided in the present application is partially crystallized. This can help reduce a contact resistance, and release space for thickening an intrinsic silicon layer. In this way, passivation effect provided by the intrinsic silicon layer is improved while energy loss in a current collection process is reduced, so that efficiency of the solar cell is improved.

According to the embodiments of the present application, a crystalline structure of the semiconductor layer in the present application is formed by processing the semiconductor layer by using a laser, and only an operation of applying the laser to the semiconductor layer needs to be added based on an original process for the solar cell. This has an advantage of simple operations.

### BRIEF DESCRIPTION OF THE DRAWINGS

The foregoing and other objectives, features, and advantages of the present application become clearer based on the descriptions of the embodiments of the present application with reference to the following accompanying drawings. In the accompanying drawings:
FIG. 1 is a schematic diagram of a partial structure of a solar cell according to an embodiment of the present application;
FIG. 2 is a schematic diagram of a partial structure of a solar cell according to another embodiment of the present application;
FIG. 3A is a cross-sectional transmission electron microscope (TEM) image of a doped amorphous silicon layer processed by using a first laser under a laser condition 1 according to an embodiment of the present application;
FIG. 3B and FIG. 3C are locally enlarged TEM images of different positions in FIG. 3A;
FIG. 3D and FIG. 3E are locally enlarged TEM images of different grain portions in FIG. 3A;
FIG. 4A is a surface scanning electron microscope (SEM) image of a doped amorphous silicon layer processed by using a first laser under a laser condition 1 according to an embodiment of the present application;
FIG. 4B and FIG. 4C are sequentially locally enlarged microscopic SEM images of a doped amorphous silicon layer in FIG. 4A;
FIG. 4D to FIG. 4F are surface SEM images of a doped amorphous silicon layer processed by using a first laser under laser conditions 2 to 4 according to an embodiment of the present application;
FIG. 5A is a cross-sectional TEM image of an amorphous silicon layer processed by using a first laser under a laser condition 1 according to another embodiment of the present application;
FIG. 5B is a locally enlarged TEM image of a grain portion on a pyramid tip portion in FIG. 5A;
FIG. 5C is a top view of a TEM image of an amorphous silicon layer in FIG. 5A;
FIG. 6A is a surface SEM image of an amorphous silicon layer processed by using a first laser under a laser condition 1 according to still another embodiment of the present application;
FIG. 6B is a cross-sectional TEM image of an amorphous silicon layer processed by using a first laser under a laser condition 1 according to yet another embodiment of the present application;
FIG. 7 is a side view of an overall structure of a solar cell according to yet another embodiment of the present application;
FIG. 8 is a TEM image of a solar cell in FIG. 7 after laser crystallization;
FIG. 9 is a schematic top view of a position relationship between an edge portion and a body portion of a first-type doped amorphous silicon layer or a second-type doped amorphous silicon layer according to yet another embodiment of the present application;
FIG. 10 is a side view of an overall structure of a solar cell according to still yet another embodiment of the present application;
FIG. 11 is a schematic top view of a position relationship between a first-type doped amorphous silicon layer and a second-type doped polycrystalline silicon layer according to still yet another embodiment of the present application;
FIG. 12A is a schematic diagram of a manufacturing process of a solar cell according to an embodiment of the present application;
FIG. 12B is a diagram of a contact resistance test result of a doped polycrystalline silicon layer 103 to which a first laser is applied according to an embodiment of the present application;
FIG. 13A to FIG. 13E are schematic diagrams of a manufacturing process of a solar cell according to a further embodiment of the present application; and
FIG. 14 is a schematic diagram of a partial structure of a solar cell according to an embodiment of the present application.

### DETAILED DESCRIPTION

To make the objectives, technical solutions, and advantages of the present application clearer, the present application is further described in detail below with reference to the accompanying drawings and specific embodiments.

The terms used herein are merely intended to describe specific embodiments, but not to limit the present application. The terms "include", "comprise", and the like used herein indicate the presence of features, steps, operations, and/or components, but do not preclude the presence or addition of one or more other features, steps, operations, or components. Unless otherwise defined, all terms (including technical and scientific terms) used herein have the same meanings as commonly understood by a person skilled in the art. It should be noted that the terms used herein should be construed as having meanings consistent with the context of this specification and should not be construed in an idealized or excessively stereotyped manner.

A relative position, for example, "on" or "above", between two components (for example, film layers or regions) mentioned in the present application may indicate that the two components are in direct contact, or may indicate that the two components are not in direct contact. Similarly, a relative position, for example, "under" or "below", between two components mentioned in the present application may indicate that the two components are in direct contact, or may indicate that the two components are not in direct contact. For example, when a component (for example, a film layer or a region) is referred to as being "on another component", the component may be directly on the another component, or another component may exist between the two components. However, when a component is referred to as being "directly on another component", no component exists between the two components. In addition, when a component is referred to as being "on another component", the two components have an upper-lower relationship along a top-view direction, and the component may be above or below the another component. Therefore, the upper-lower relationship depends on an orientation of an apparatus.

For a solar cell, to reduce a contact resistance and improve performance of the solar cell, a contact structure between, for example, a metal electrode and a transparent conductive film layer is usually improved, and a contact structure of a semiconductor layer is less likely to be improved. During implementation of the concept of the present application, it is found that crystallization modification of a semiconductor layer on a silicon substrate may be implemented through laser processing on the semiconductor layer, so that the semiconductor layer presents particular crystallized morphology along a direction away from a surface of the silicon substrate. It is verified through further experiments that, after the particular crystallized morphology is formed the semiconductor layer through laser processing, a current transmission characteristic between the semiconductor layer and a conductive material layer such as a transparent conductive layer or a metal electrode layer can be effectively improved, to improve performance of the solar cell.

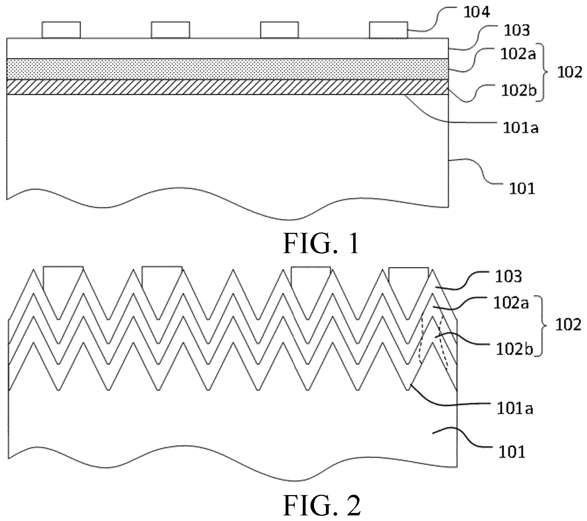

Specifically, according to an embodiment of one aspect of the present application, a solar cell is provided. FIG. 1 is a schematic diagram of a partial structure of a solar cell according to an embodiment of the present application. FIG. 2 is a schematic diagram of a partial structure of a solar cell according to another embodiment of the present application. As shown in FIG. 1 and FIG. 2, the solar cell in this embodiment of the present application mainly includes a silicon substrate 101 and a first semiconductor layer 102. The silicon substrate includes a first surface 101a and a second surface that are opposite to each other. The first semiconductor layer 102 is located on the first surface 101a. The first semiconductor layer 102 includes a second structural region 102b and a first structural region 102a. A crystallization degree of the first structural region 102a is higher than a crystallization degree of the second structural region 102b. The second structural region 102b is closer to the first surface 101a than the first structural region 102a. The first semiconductor layer 102 includes at least one of amorphous silicon, nanocrystalline silicon, or microcrystalline silicon.

It should be noted that the "crystallization degree" is used for representing a crystalline volume fraction, a grain size, and a quantity of grains. Usually, a higher crystallization degree indicates a larger crystalline volume fraction, a larger grain size, and/or a larger quantity of grains. For example, when the first semiconductor layer is a nanocrystalline silicon layer (the nanocrystalline silicon layer usually still includes an amorphous silicon part, which is inevitable, but a proportion of the amorphous silicon part is small, which is known in the art), the first structural region 102a with a higher crystallization degree has a larger crystalline volume fraction and/or a larger grain size than the second structural region 102b. When the first semiconductor layer is an amorphous silicon layer (the amorphous silicon may include a small nanocrystalline silicon part, but a proportion of the nanocrystalline silicon part is quite small, for example, less than 5%, which is known in the art), grains with ordered lattices are formed in the first structural region 102a with a higher crystallization degree, and the crystallization degree of the first structural region 102a increases. However, the second structural region 102b with a lower crystallization degree is still made of an amorphous silicon material, and does not include grains formed after laser processing or the like. For sampling of a crystallization degree, because sampling in a region with a high crystallization degree is also performed locally rather than in an entire laser processing region, a sampling area should be a square region with a size greater than or equal to 5 µm × 5 µm. Comparison is performed based on a crystallization degree in a region with this area.

In an embodiment, a crystalline volume fraction of the second structural region 102b is greater than or equal to 10%, and/or a difference between the crystalline volume fraction of the second structural region and a crystalline volume fraction of the first structural region is less than or equal to 10%. The large crystalline volume fraction of the second structural region 102b can ensure a small contact resistance, and the difference between the crystalline volume fraction of the second structural region and the crystalline volume fraction of the first structural region can implement transmission continuity of the first semiconductor layer, to improve current collection efficiency.

According to an embodiment of the present application, the first structural region 102a and/or the second structural region 102b may be located on at least a part of the first surface of the silicon substrate 101. To be specific, the first structural region 102a and/or the second structural region 102b may cover the first surface 101a of the silicon substrate 101, as shown in FIG. 1; or may be located in a partial region of the first surface 101a of the silicon substrate 101, for example, may be located on a pyramid tip portion of at least one pyramid structure of the silicon substrate 101, as indicated by dashed lines in FIG. 2.

Further, the first structural region 102a and the second structural region 102b may be determined based on obvious layering of a crystallization degree of the first semiconductor layer 102. For example, the first structural region 102a includes nanocrystalline silicon, and the second structural region 102b may not include or may not obviously include nanocrystalline silicon. For example, a crystalline volume fraction being less than 5%, for example, less than 1%, may be defined as not obviously including nanocrystalline silicon. Certainly, the first structural region 102a and the second structural region 102b may alternatively be determined based on material layering of the first semiconductor layer 102. For example, when the first semiconductor layer 102 is an amorphous silicon layer, layering may be performed based on intrinsic silicon and doped silicon.

According to an embodiment of the present application, the silicon substrate 101 may be an N-type or P-type crystalline silicon substrate, for example, may be made of a semiconductor material such as monocrystalline silicon, polycrystalline silicon, or microcrystalline silicon. In an embodiment, the silicon substrate 101 is an N-type or P-type monocrystalline silicon substrate. Conversion efficiency of a solar cell based on the monocrystalline silicon substrate is higher than that of another type of solar cell, for example, a polycrystalline silicon solar cell. Donor impurities, such as a phosphorus (P), arsenic (As), or antimony (Sb) element, are introduced into these semiconductor materials to obtain an N-type crystalline silicon substrate. Alternatively, acceptor impurities, such as the boron (B), aluminum (Al), or gallium (Ga) element, are introduced into these semiconductor materials to obtain a P-type crystalline silicon substrate.

According to an embodiment of the present application, at least some regions of the first semiconductor layer 102 may be doped or non-doped, when the first semiconductor layer 102 is doped, a doping type may be N-type doping or P-type doping. This may be specifically determined based on a type of the solar cell and a doping type of the silicon substrate. Similar to the case of the silicon substrate 101, donor impurities or acceptor impurities are introduced into a main material of the first semiconductor layer 102 to obtain different doping types.

According to an embodiment of the present application, the solar cell of the present application is mainly applicable to a heterojunction solar cell, which may be a heterojunction with intrinsic thin-layer (HJT) solar cell, a heterojunction back contact (HBC) solar cell, or a hybrid HBC solar cell, for example, a TOPCon back contact (TMC)-HJT hybrid solar cell. The solar cell is applicable to all solar cells in which contact performance between a first semiconductor layer and a conductive material layer needs to be improved.

According to an embodiment of the present application, the applicant finds through experiments that a crystallization degree of a partial region, away from the silicon substrate, of the first semiconductor layer can be increased through laser processing on the first semiconductor layer, to reduce a contact resistance of the first semiconductor layer. In addition, another partial region, with a low crystallization degree, of the first semiconductor layer can ensure passivation effect of the first semiconductor layer. That is, a balance is achieved between the contact resistance and the passivation effect.

According to an embodiment of the present application, the second structural region includes a first intrinsic silicon layer with a thickness ranging from 5 nm to 30 nm, for example, 5 nm, 8 nm, 10 nm, 13 nm, 15 nm, 18 nm, 20 nm, 25 nm, 28 nm, or 30 nm. In an embodiment, the thickness of the first intrinsic silicon layer ranges from 8 nm to 20 nm. Because the contact resistance of the first semiconductor layer 102 is reduced, space is provided for releasing the thickness of the first intrinsic silicon layer. This helps improve passivation effect of the first intrinsic silicon layer, to improve efficiency of the solar cell.

According to an embodiment of the present application, the first semiconductor layer 102 includes a plurality of grains, and a maximum size of the plurality of grains is less than a thickness of the first semiconductor layer 102.

From the perspective of a grain size, a first part of the first semiconductor layer 102 includes grains, and a maximum size of the grains may be equal to a thickness of the first part. In this case, the first part of the first semiconductor layer 102 has high conductivity. This can further reduce transmission loss of transmitting carriers collected in the first semiconductor layer 102 to a conductive material. However, during actual manufacturing, a larger grain size in the first part of the first semiconductor layer 102 indicates higher temperature for crystallizing the first part of the first semiconductor layer 102, and further causes a larger amount of hydrogen spillover in the first semiconductor layer 102. Consequently, passivation effect of the second structural region 102b on the silicon substrate is degraded. Therefore, when the grain size in the first part of the first semiconductor layer 102 is less than the thickness of the first part, crystallization temperature corresponding to the first semiconductor layer 102 is low. In this way, a part, in which no grain extendedly grows, of the first semiconductor layer 102 has passivation effect on the semiconductor substrate. This helps achieve a balance between passivation effect and transmission loss that correspond to the first semiconductor layer 102, and further improves operation performance of the solar cell.

According to an embodiment of the present application, a material of the second structural region 102b includes intrinsic amorphous silicon, and a material of the first structural region 102a includes amorphous silicon and nanocrystalline silicon, but is less likely to include microcrystalline silicon, or is even considered as not including microcrystalline silicon because a possibility is excessively low. Therefore, the crystalline volume fraction of the first structural region 102a is greater than that of the second structural region 102b, to achieve a balance between improvement of the passivation effect and a reduction in the contact resistance. Further, in an embodiment, the material of the first structural region 102a includes amorphous silicon and nanocrystalline silicon with a grain size ranging from 5 nm to 25 nm (which may be, for example, 5 nm, 10 nm, 15 nm, 20 nm, or 25 nm).

According to an embodiment of the present application, the first surface 101a of the silicon substrate 101 may have a polished region including a pyramid base structure, or may have a textured region including a pyramid structure. First semiconductor layers 102 formed in different regions vary in morphology, and specifically vary in crystalline structures and porous morphology. The pyramid base structure of the polished region in the present application may be a short convex truncated pyramid structure or a shallow concave groove structure.

Specifically, as shown in FIG. 1, for example, the first surface 101a of the silicon substrate 101 has a polished region including a pyramid base structure, the first semiconductor layer 102 is formed in the polished region, and a crystalline structure is mainly located in a part, away from the first surface 101a, of the first semiconductor layer 102. In this case, the first structural region 102a and the second structural region 102b may be determined through division based on morphology and/or a material of the first semiconductor layer 102. The morphology based on which the division is performed may be, for example, a crystalline structure and an amorphous structure. The material may be, for example, intrinsic silicon and doped silicon.

Further, in an embodiment, the first structural region 102a and the second structural region 102b may be determined based on the obvious layering of the crystallization degree of the first semiconductor layer 102. In this case, the second structural layer 102b may include an intrinsic silicon layer, and may further include a part of a doped silicon layer, and the first structural layer 102a may include at least a part of the doped silicon layer.

Certainly, the first structural region 102a and the second structural region 102b may alternatively be layered based on intrinsic silicon and doped silicon. For the polished region, a crystalline structure of an amorphous silicon layer 102 is mainly located in the doped silicon layer. Therefore, it is also considered that the crystallization degree of the first structural region 102a is higher than that of the second structural region 102b.

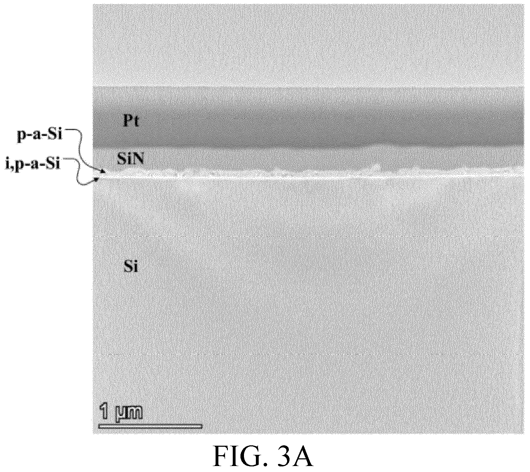

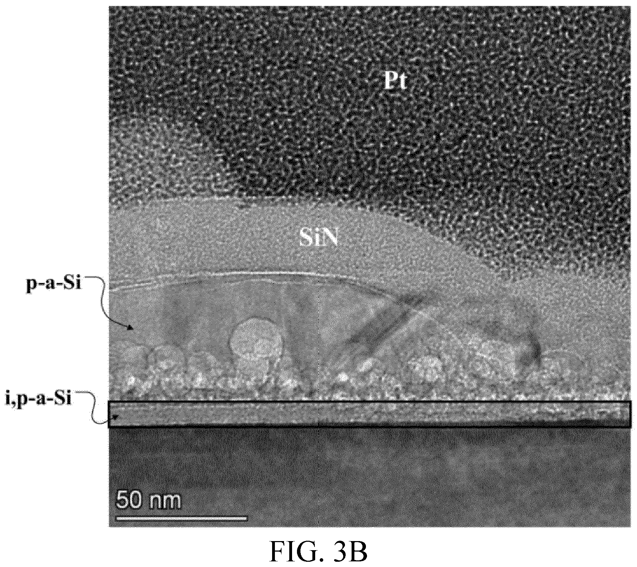

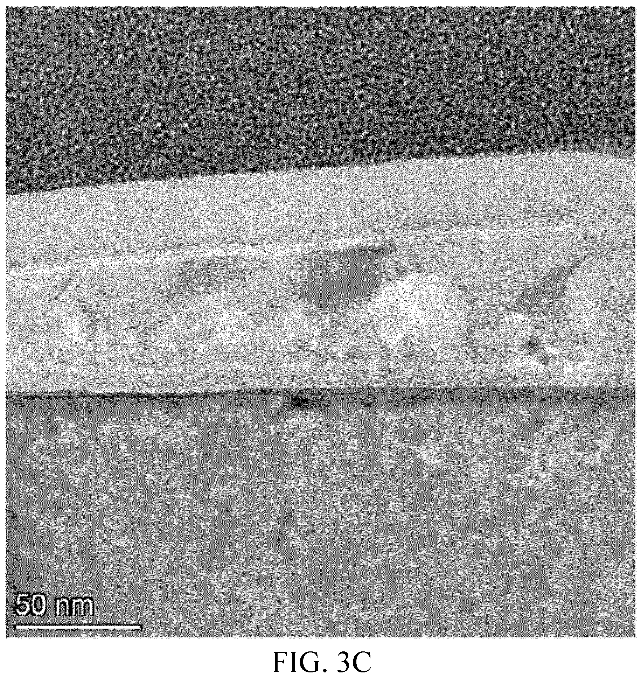

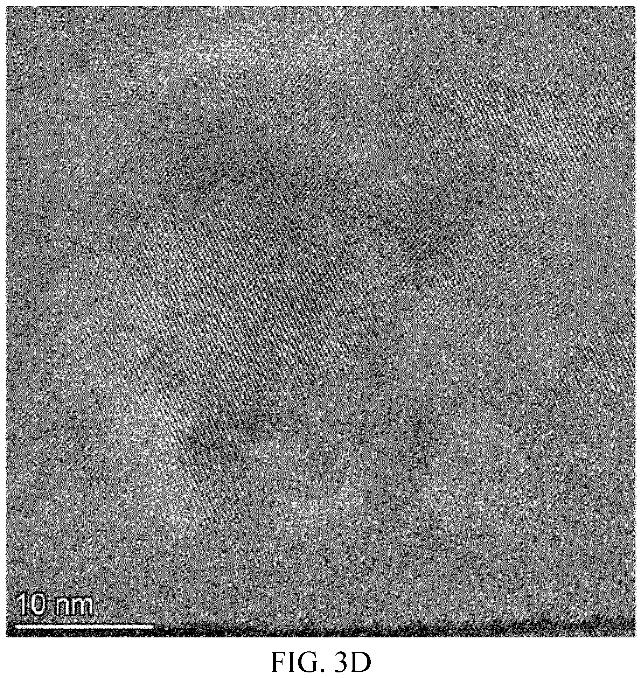

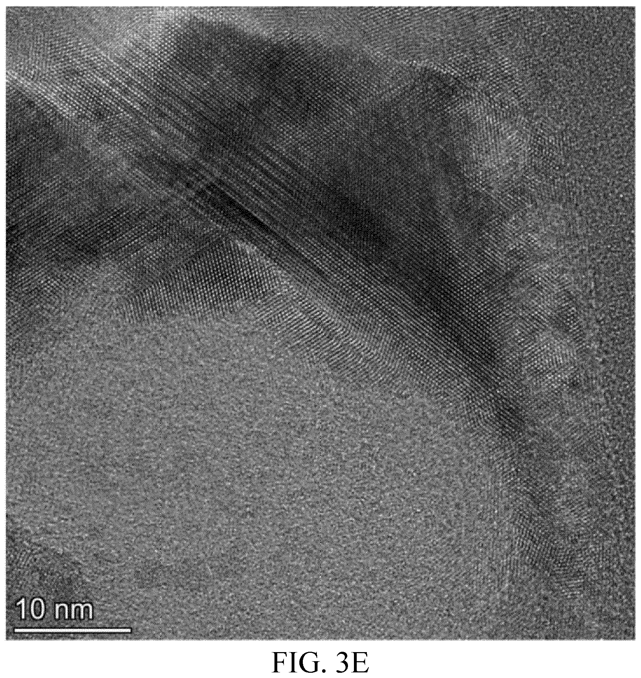

For example, the first semiconductor layer 102 is an amorphous silicon layer. Cross-sectional microscopic morphology of the first semiconductor layer 102 to which a first laser is applied is observed by using a TEM. Specifically, first, a first intrinsic amorphous silicon (i-a-Si) layer and a P-type doped amorphous silicon (p-a-Si) layer are sequentially deposited on a polished surface of the silicon substrate 101. Then a p-a-Si layer with a thickness ranging from 10 nm to 40 nm is processed by using the first laser under a laser condition 1, to form a p-a-Si layer of a porous structure. Then a SiN layer and a Pt layer are sequentially deposited on a surface of the p-a-Si layer, to obtain a silicon sheet suitable for detection by the TEM. FIG. 3A is a cross-sectional TEM image of an amorphous silicon layer processed by using the first laser under the laser condition 1 according to an embodiment of the present application. FIG. 3B and FIG. 3C are locally enlarged TEM images of different positions in FIG. 3A. FIG. 3D and FIG. 3E are locally enlarged TEM images of different grain portions in FIG. 3A. SiN is a protective layer used during testing.

As shown in FIG. 3A to FIG. 3E, it can be observed that the first semiconductor layer 102 is partially crystallized after being processed by using the first laser, and a layered structure, that is, the first structural region 102a and the second structural region 102b, is formed. As shown in FIG. 3B, a rectangular block indicates the second structural region 102b (namely, i, p-a-Si), and the first structural region 102a (namely, p-a-Si) is above the rectangular block. Circular grain portions may be observed in the first structural region 102a shown in FIG. 3B and FIG. 3C. Ordered lattice structures may be observed in grain portions shown in FIG. 3D and FIG. 3E, indicating that amorphous silicon in the first structural region 102a is partially crystallized. The ordered lattice structures are nanocrystalline silicon. It can be learned that, in addition to retained amorphous silicon, a material of the first structural region 102a may further include nanocrystalline silicon obtained through crystallization. This is an advantage of laser processing on an amorphous silicon layer over processing on a nanocrystalline silicon layer and a microcrystalline silicon layer. In this way, the amorphous silicon layer can be partially crystallized to achieve current collection effect similar to that of the nanocrystalline silicon layer and the microcrystalline silicon layer, and a high deposition rate and low costs of the amorphous silicon layer can also be leveraged.

In an embodiment, crystallization degrees of the first structural region 102a and the second structural region 102b are gradient. To be specific, along a direction away from the first surface of the silicon substrate, both a crystallization degree and a grain size of the first semiconductor layer 102 gradually increase.

According to an embodiment of the present application, the first semiconductor layer 102 located in the polished region may form a porous structure while being crystallized. In other words, the first semiconductor layer 102 located in the polished region may further have a porous structure. In this way, a contact area between the first semiconductor layer 102 and a conductive material layer can be increased. This helps further improve a current transmission characteristic of the first semiconductor layer 102. Further, in an embodiment, the first structural region 101a has a porous structure, and the second structural region 102b has a porous structure or a non-porous structure, to facilitate contact with the conductive material layer.

Further, in an embodiment, still as shown in FIG. 1, the solar cell of the present application may further include a transparent conductive layer 103 that serves as the foregoing conductive material layer and that is located on a surface, away from the silicon substrate 101, of the first semiconductor layer 102. The transparent conductive layer 103 may be in contact with the porous structure of the first semiconductor layer 102, and specifically, may be in contact with the porous structure of the first structural region 101a, to increase a contact area and improve a current transmission performance between the first semiconductor layer 102 and the transparent conductive layer 103. The transparent conductive layer 103 fully covers the first structural region 102a. In this way, a region with a high crystallization degree can completely overlap with the transparent conductive layer 103, so that a contact resistance is small.

According to an embodiment of the present application, a partial region of the first semiconductor layer 101 may form a porous structure based on a suitable laser processing condition. It is presumed that, after laser energy is absorbed by a film layer, temperature of the film layer increases, the film layer enters a molten state, and hydrogen escapes from the film layer, causing the porous structure. Therefore, laser processing on the first semiconductor layer 102 is proposed, to enable the first semiconductor layer 102 to form the porous structure. Because the first semiconductor layer 102 has the porous structure, a contact area between the first semiconductor layer 102 and the transparent conductive layer 103 can be increased, to reduce a current transmission resistance between the first semiconductor layer 102 and the transparent conductive layer 103, so that energy loss in a current collection process is reduced, and efficiency of the solar cell is improved.

According to an embodiment of the present application, the first structural region 102a has a first porous structure, and the second structural region 102b has a second porous structure. A pore size of the second porous structure is smaller than a pore size of the first porous structure. The porous structure weakens passivation effect and lowers current collection efficiency of the solar cell. Therefore, the pore size of the second porous structure is set to be smaller than the pore size of the first porous structure, to ensure passivation effect of the first semiconductor layer 102 while improving contact performance of the first semiconductor layer 102.

Further, in an embodiment, the first porous structure has a plurality of first pores arranged in a run-through manner, the second porous structure includes a plurality of second pores, and the plurality of second pores are exposed from the plurality of first pores. The via morphology of the first structural region 102a enables the transparent conductive layer 103 to be separately in contact with the first structural region 102a and the second structural region 102b, to ensure that a process of forming porous morphology of the first structural region 102a does not affect a layer structure under the second structural region 102b, while increasing a contact area with the transparent conductive layer 104. This arrangement better facilitates a balance between improvement of contact performance and improvement of passivation effect.

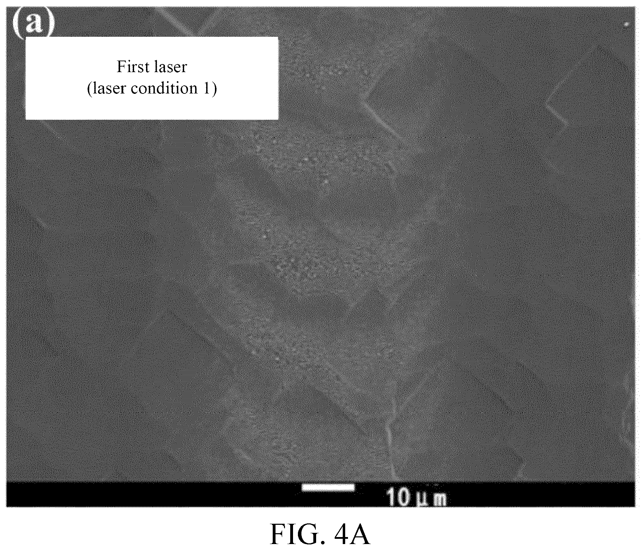

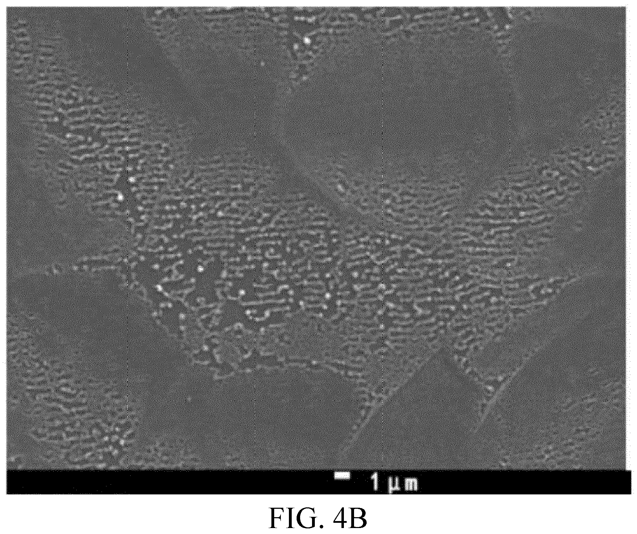

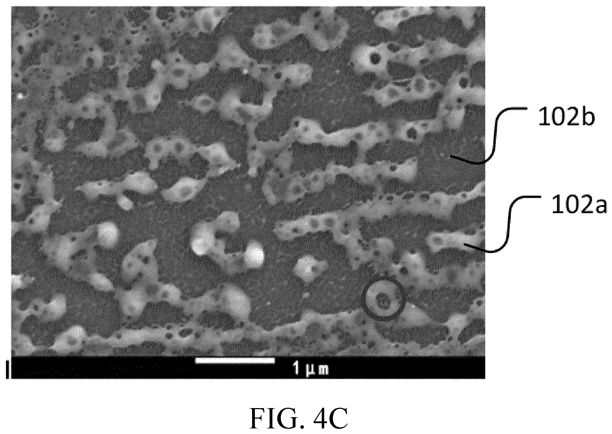

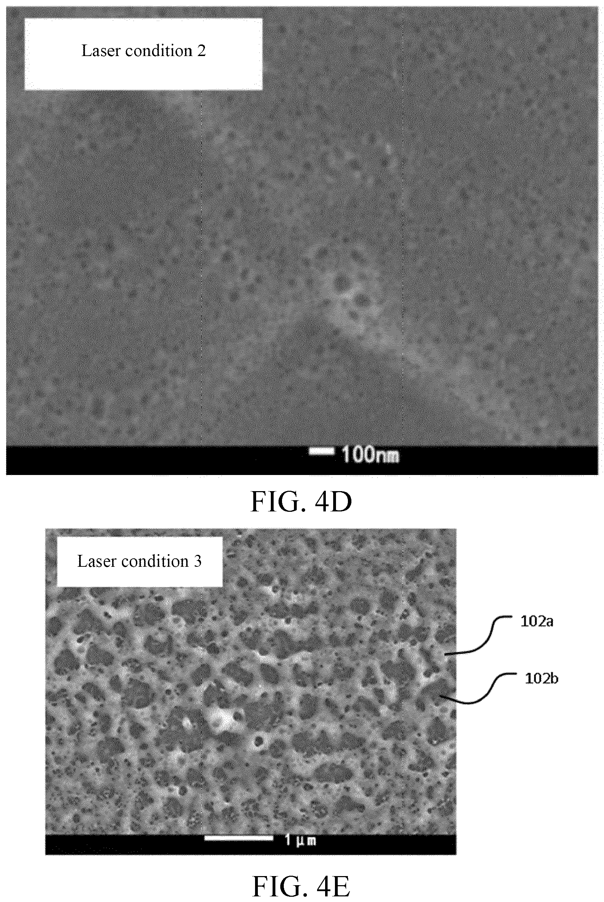

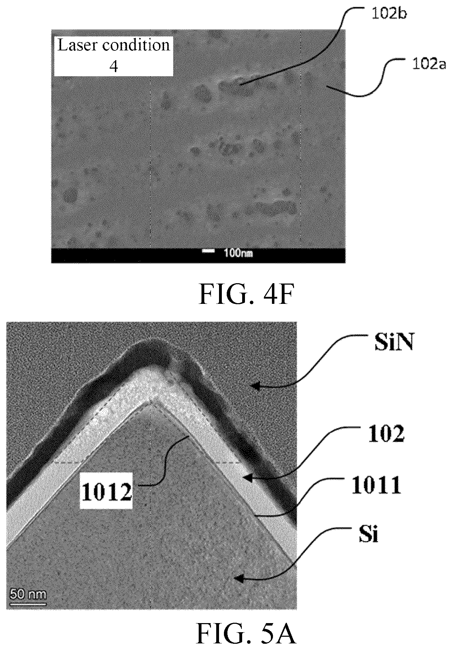

For ease of description, for example, the first semiconductor layer 102 is still an amorphous silicon layer. Surface morphology of the first semiconductor layer 102 is observed by using a SEM. FIG. 4A is a surface SEM image of an amorphous silicon layer processed by using the first laser under the laser condition 1 according to an embodiment of the present application. FIG. 4B and FIG. 4C are sequentially locally enlarged microscopic SEM images of the amorphous silicon layer in FIG. 4A. As shown in FIG. 4A to FIG. 4C, a dark-colored region is the second structural region 102b, a light-colored region is the first structural region 102a, and an obvious porous structure can be seen.

According to an embodiment of the present application, the second structural region 102b may have non-porous or porous morphology. In an embodiment, as shown in FIG. 4C, the second structural region 102b is formed to be of the second porous structure, and the pore size of the second porous structure is smaller than the pore size of the first porous structure. Further, in an embodiment, as indicated by a circle in FIG. 4C, the second structural region 102b has a plurality of second pores, and the plurality of second pores are exposed from the plurality of first pores. In this way, a layered nested porous structure is formed between the first structural region 102a and the second structural region 102b.

According to an embodiment of the present application, the second structural region 102b is formed to be of the second porous structure, and forms a layered nested porous structure with the first structural region 102a, to further increase a contact area with the transparent conductive layer 103. This helps reduce a current transmission resistance and improve efficiency of the solar cell.

According to an embodiment of the present application, further, the pore size of the first porous structure is less than or equal to 1 µm. For example, the pore size may be less than 1 µm, less than 0.8 µm, less than 0.5 µm, less than 0.3 µm, or less than 0.1 µm. In an embodiment, the pore size is less than or equal to 0.3 µm.

According to an embodiment of the present application, further, the pore size of the second porous structure is less than or equal to 300 nm. For example, the pore size may be less than 0.3 µm, less than 0.1 µm, less than 0.08 µm, less than 0.06 µm, or less than 0.04 µm. In an embodiment, the pore size is less than or equal to 0.3 µm.

It should be noted that the "pore size" of the first porous structure or the second porous structure is a pore size range of main pores of the porous structure. For one pore, a pore size may be a diameter of a circle to which a shape of the pore along a surface direction is equivalent. The main pores may be pores that account for more than 50%, for example, more than 80%, or for another example, more than 90%, of a quantity of all pores.

According to an embodiment of the present application, a pore size of the first semiconductor layer 102 is controlled to be within the foregoing range. This better helps reduce a contact resistance and improve efficiency of the solar cell.

According to an embodiment of the present application, the first surface 101a of the silicon substrate 101 may have a textured region including a plurality of pyramid structures. As shown in FIG. 2, the first structural region 102a and the second structural region 102b are located in partial regions of the first surface 101a, and further, may be determined based on material layering. For example, the first structural region 102a is a doped silicon layer, and the second structural region 102b is an intrinsic silicon layer, a crystallization degree of the doped silicon layer being higher than a crystallization degree of the intrinsic silicon layer.

Further, along a direction away from the first surface 101a, each of the pyramid structures includes a pyramid base portion 1011 and a pyramid tip portion 1012. Both the first structural region 102a and the second structural region 102b are located on the pyramid tip portion 1012, and a crystallization degree of the second structural region 102b located on the pyramid tip portion 1012 is higher than a crystallization degree of a first semiconductor layer 102 located on the pyramid base portion 1011.

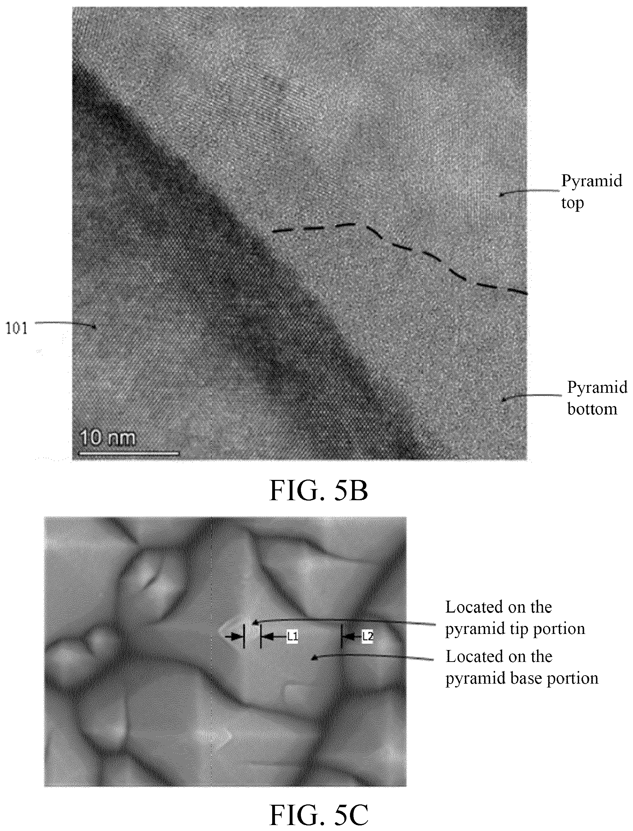

For example, the first semiconductor layer 102 is still an amorphous silicon layer. Cross-sectional microscopic morphology of the first semiconductor layer 102 to which the first laser is applied is observed by using a TEM. Specifically, first, a first i-a-Si layer and a p-a-Si layer are sequentially deposited on a textured surface of the silicon substrate 101. Then a p-a-Si layer with a thickness ranging from 10 nm to 40 nm is processed by using the first laser under a laser condition 1, to form a p-a-Si layer of a crystalline structure. Then a SiN layer and a Pt layer are sequentially deposited on a surface of the p-a-Si layer, to obtain a silicon sheet suitable for detection by the TEM. FIG. 5A is a cross-sectional TEM image of an amorphous silicon layer processed by using the first laser under the laser condition 1 according to another embodiment of the present application. FIG. 5B is a locally enlarged TEM image of a grain portion on a pyramid tip portion in FIG. 5A. FIG. 5C is a top view of a TEM image of the amorphous silicon layer in FIG. 5A.

As shown in FIG. 5A and FIG. 5B, it can be observed that the first semiconductor layer 102 is partially crystallized after being processed by using the first laser, and a crystalline structure different from that shown in FIG. 3A and FIG. 3B is formed. To be specific, a crystallization degree of a first semiconductor layer 102 located on the pyramid tip portion 1012 mainly increases, and further, the first semiconductor layer 102 includes nanocrystalline silicon. In addition, it can still be observed that a crystallization degree (a crystalline volume fraction, a quantity of grains, and a grain size) of the first structural region 102a is higher than a crystallization degree of the second structural region 102b. As shown in FIG. 5A, the first semiconductor layer 102 located on the pyramid tip portion 1012 is indicated by dashed lines, and circular grain portions can be observed. As shown in FIG. 5B, an ordered lattice structure may be observed in the grain portion of the first semiconductor layer 102 located on the pyramid tip portion, indicating that amorphous silicon located on the pyramid tip portion 1012 is partially crystallized. The ordered lattice structure is nanocrystalline silicon. Similarly, it is also found that partial crystallization of the first semiconductor layer 102 can help improve current collection effect. A thickness of the first structural region 102a may be 25 nm or more, to be specific, may be 25 nm or more away from a pyramid surface of the silicon substrate along a thickness direction of the first semiconductor layer 102, and the first structural region 102a includes only a doped silicon layer. A thickness of the second structural region 102b may be 15 nm or less, to be specific, may be 15 nm or less close to the pyramid surface of the silicon substrate along the thickness direction of the first semiconductor layer 102. In an embodiment, the first structural region 102a and the second structural region 102b do not have an obvious interface in the pyramid structure (this is also true on the pyramid tip of a porous structure). As shown in FIG. 5A, along a direction away from the pyramid surface of the silicon substrate, both a crystallization degree and a grain size of the first semiconductor layer 102 gradually increase.

According to an embodiment of the present application, it is found through experiments that, when a surface of the silicon substrate 101 is a polished surface with a pyramid base structure, a porous structure is likely to be formed in the first semiconductor layer 102 on the surface; and when the surface is a textured surface, generation of a porous structure is hardly observed. However, through selection of a suitable laser processing condition, when the first surface is a textured surface, a porous structure may still be controlled to be formed in a particular region of the first semiconductor layer 102 on the first surface.

Further, in an embodiment, the first semiconductor layer 102 located on the pyramid tip portion 1012 may form a porous structure or a non-porous structure while being crystallized. A first semiconductor layer 102 of a non-porous structure is more easily obtained through laser processing. As shown in FIG. 5C, no obvious porous structure is observed in the first semiconductor layer 102 located on the pyramid tip portion.

Further, in an embodiment, as shown in FIG. 5C, the first semiconductor layer 102 located on the pyramid structure has a side surface extending from top to bottom. Along an extension direction of the side surface, a ratio of a maximum extension length L1, on the side surface, of the first semiconductor layer located on the pyramid tip portion to a length L2 of the side surface is less than or equal to 0.3, for example, may be 0.05, 0.1, 0.15, 0.2, 0.25, or 0.3. In this arrangement, the first semiconductor layer located on the pyramid base portion mainly provides passivation effect, and the first semiconductor layer located on the pyramid tip portion mainly provides contact performance optimization effect.

In other embodiments, a suitable laser processing condition may be selected to enable a porous structure 102c to be formed in the first semiconductor layer 102 located on the pyramid tip portion 1012. The first semiconductor layer 102 of the porous structure 102c helps further increase a contact area between the first semiconductor layer 102 and the transparent conductive layer, and helps further improve a current transmission characteristic of the first semiconductor layer 102.

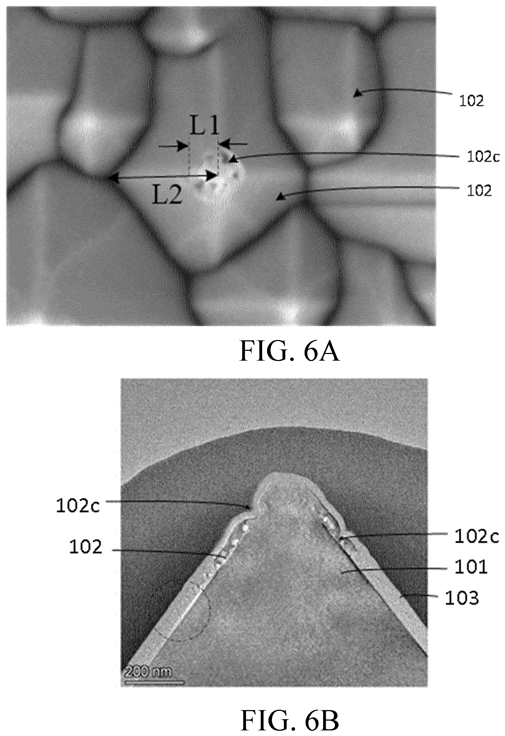

According to an embodiment of the present application, to further describe the porous structure of the first semiconductor layer 102 of the present application, FIG. 6A is a surface SEM image of a doped amorphous silicon layer processed by using the first laser under the laser condition 1 according to still another embodiment of the present application. FIG. 6B is a cross-sectional TEM image of a doped amorphous silicon layer processed by using the first laser under the laser condition 1 according to yet another embodiment of the present application.

As shown in FIG. 6A and FIG. 6B, at least one pore included in the porous structure is a blind via that does not penetrate through the first semiconductor layer 102. Because a part, corresponding to the blind via, of the first semiconductor layer 102 still has a specific thickness, a partial surface of the silicon substrate 101 can be passivated. This can achieve a balance between improvement of current transmission performance and improvement of passivation effect. Further, in an embodiment, a pore size of at least one pore included in the porous structure 102c is less than 100 nm, for example, may be less than or equal to 80 nm, less than or equal to 60 nm, or less than or equal to 50 nm. Further, still as shown in FIG. 6A, the first semiconductor layer located on the pyramid structure has a side surface extending from the pyramid tip portion to the pyramid bottom. Along an extension direction of the side surface, a ratio of a distribution length L1 of the porous structure 102c on the side surface to a length L2 of the side surface is less than or equal to 0.5, for example, may be 0.05, 0.1, 0.15, 0.2, 0.25, 0.3, 0.35, 0.4, 0.45, or 0.5. In this arrangement, the first semiconductor layer located on the pyramid base portion mainly provides passivation effect, and the first semiconductor layer located on the pyramid tip portion mainly provides contact performance optimization effect.

Further, still as shown in FIG. 6C, a thickness of a part, without the porous structure 102c, of the first semiconductor layer 102 is greater than or equal to 10 nm; and/or the thickness of the part, without the porous structure, of the first semiconductor layer 102 is less than or equal to 45 nm. For example, the thickness of the first semiconductor layer may be 10 nm, 15 nm, 20 nm, 25 nm, 30 nm, 35 nm, 40 nm, or 45 nm.

From one perspective, because intensity of light absorbed by a film layer decreases exponentially with a depth. Therefore, a thicker film layer indicates lower interface temperature between the silicon substrate and the first semiconductor layer 102 when a surface film layer reaches same high temperature, and indicates weaker passivation damage. This can avoid a problem that, when the film layer is excessively thin, laser processing causes excessively high temperature of the silicon substrate 101 and the first semiconductor layer 102, leading to deterioration of passivation effect. From another perspective, thickening of the film layer helps mitigate heat dissipation, and also helps achieve high temperature on a surface of the film layer.

According to an embodiment of the present application, still as shown in FIG. 1 and FIG. 2, the solar cell may further include an electrode 104, and the electrode 104 is located on a surface of the transparent conductive layer 103. The electrode 104 may be made of, for example, silver, copper, silver-coated copper, or aluminum, and is manufactured through patterning by using a vacuum evaporation, electroplating, or screen printing process or the like.

According to an embodiment of the present application, along a direction parallel to the first surface 101a, the first semiconductor layer 102 includes a body portion and an edge portion adjacent to a periphery of the body portion, a crystallization degree of the body portion being higher than a crystallization degree of the edge portion. Herein, "adjacent" indicates that the body portion is in contact with the edge portion, to integrally form the first semiconductor layer 102.

For example, the body portion is approximately in a strip shape or a rectangular shape extending along a first direction, and the edge portion may be distributed on two side edges of the body portion along the first direction, or may be distributed on two side edges of the body portion along a second direction perpendicular to the first direction, or may surround the periphery of the body portion to form an annular shape.

This arrangement can reduce damage caused by, for example, laser processing to the thin edge portion, to ensure passivation effect, and can further isolate a defect of the edge portion, to suppress carrier recombination.

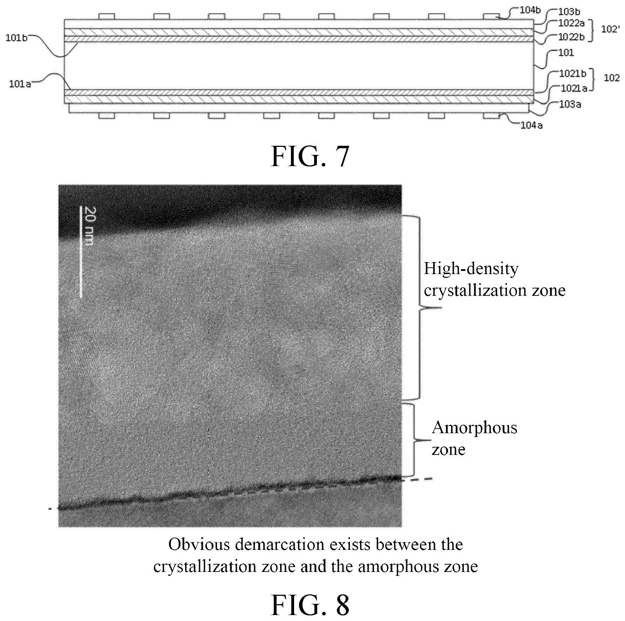

According to an embodiment of the present application, an HJT solar cell is used as an example to further describe the solar cell of the present application. FIG. 7 is a side view of an overall structure of a solar cell according to yet another embodiment of the present application. As shown in FIG. 1 and FIG. 7, a silicon substrate 101 includes a first surface 101a and a second surface 101b that are opposite to each other. The first surface 101a of the silicon substrate 101 is a polished surface including a pyramid base structure and may be used as a non-illuminated surface. In this case, a first structural region 102a includes a first-type doped amorphous silicon layer 1021a located on the first surface 101a of the silicon substrate 101, and a second structural region 102b includes a first intrinsic amorphous silicon layer 1021b, which forms an amorphous silicon layer with the first-type doped amorphous silicon layer 1021a. The amorphous silicon layer is used as a first semiconductor layer 102.

FIG. 8 is a TEM image of the solar cell in FIG. 7 after laser crystallization. As shown in FIG. 8, in the solar cell in this embodiment, under the action of laser, amorphous silicon on a side, close to a first transparent conductive layer 103a, of the first semiconductor layer 102, that is, a side, away from the first surface 101a, of the first semiconductor layer 102, is converted into crystalline silicon.

According to an embodiment of the present application, a thickness of the first-type doped amorphous silicon layer 1021a ranges from 10 nm to 45 nm, for example, may be 10 nm, 15 nm, 20 nm, 25 nm, 30 nm, 35 nm, 40 nm, or 45 nm.

The thickness of the first-type doped amorphous silicon layer 1021a falls within the foregoing range. From one perspective, because intensity of light absorbed by a film layer decreases exponentially with a depth. Therefore, a thicker film layer indicates lower interface temperature between the silicon substrate and the first intrinsic amorphous silicon layer when a surface film layer reaches same high temperature, and indicates weaker passivation damage. This can avoid a problem that, when the film layer is excessively thin, laser processing causes excessively high temperature of the silicon substrate 101 and the first intrinsic amorphous silicon layer 1021b, leading to deterioration of passivation effect. From another perspective, thickening of the film layer helps mitigate heat dissipation, and also helps achieve high temperature on a surface of the film layer.

As shown in FIG. 7, according to an embodiment of the present application, the solar cell further includes a second intrinsic amorphous silicon layer 1022b and a second-type doped amorphous silicon layer 1022a that are sequentially arranged on the second surface 101b. The second intrinsic amorphous silicon layer 1022b and the second-type doped amorphous silicon layer 1022a form another amorphous silicon layer, which is used as a second semiconductor layer 102'. Alternatively, the second semiconductor layer 102' may or may not be of a crystalline structure similar to that of the first semiconductor layer 102.

When the second semiconductor layer 102' has a crystalline structure similar to that of the first semiconductor layer 102, the solar cell further includes the second semiconductor layer 102' located on the second surface 101b. The second semiconductor layer 102' includes a fourth structural region (namely, the second intrinsic amorphous silicon layer 1022b) and a third structural region (namely, the second-type doped amorphous silicon layer 1022a). A crystallization degree of the third structural region is higher than a crystallization degree of the fourth structural region. The fourth structural region is closer to the second surface 101b than the third structural region, and the second semiconductor layer 102' includes at least one of amorphous silicon, nanocrystalline silicon, or microcrystalline silicon. Herein, a doping type of first-type doping is opposite to a doping type of second-type doping. For example, the first-type doped amorphous silicon layer 1021a may be an N-type doped amorphous silicon layer, and in this case, the second-type doped amorphous silicon layer 1022a may be a P-type doped amorphous silicon layer. Alternatively, a polarity of the first-type doped amorphous silicon layer 1021a and a polarity of the second-type doped amorphous silicon layer 1022a may be interchanged.

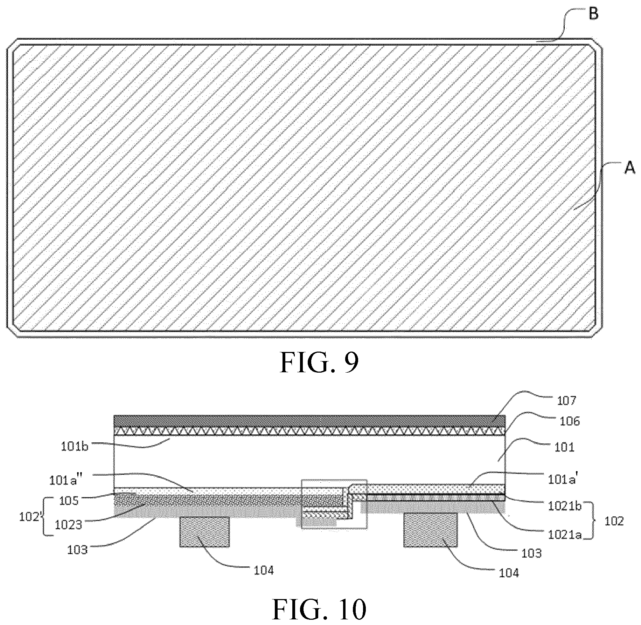

Because nanocrystalline silicon is mainly located in a doped silicon layer, a crystalline structure of the first-type doped amorphous silicon layer or the second-type doped amorphous silicon layer is further described. FIG. 9 is a schematic top view of a position relationship between an edge portion and a body portion of the first-type doped amorphous silicon layer or the second-type doped amorphous silicon layer according to yet another embodiment of the present application. As shown in FIG. 9, the first semiconductor layer 102 covers the first surface 101a entirely, or the second semiconductor layer 102' covers the second surface 101b entirely. From a top-view perspective, it can be observed that the corresponding first-type doped amorphous silicon layer 1021a and/or second-type doped amorphous silicon layer 1022a each include a body portion A and an edge portion B surrounding a periphery of the body portion. The edge portion B is in an annular shape. Further, in an embodiment, the body portion A includes nanocrystalline silicon, and the edge portion B does not include nanocrystalline silicon. Therefore, a crystallization degree of the body portion A is higher than a crystallization degree of the edge portion B. Because the edge portion B is thin and has a large quantity defects and a high electron-hole recombination rate, the edge portion B is designed to not include nanocrystalline silicon. This can reduce damage caused by, for example, laser processing to the thin edge portion B, to ensure passivation effect, and can further isolate a defect of the edge portion, to suppress carrier recombination.

Further, in an embodiment, the body portion A is mainly located in an electrode contact region of the solar cell, and the edge portion B is mainly located in a non-electrode contact region of the solar cell, so that a crystallization degree of the electrode contact region is higher than a crystallization degree of the non-electrode contact region. This better helps improve a current transmission characteristic of a doped amorphous silicon layer. Herein, the "electrode contact region" is a region in which an electrode can be in contact with the doped amorphous silicon layer.

According to an embodiment of the present application, when the first surface 101a of the silicon substrate 101 is a textured surface including a pyramid structure, the foregoing structural settings of the edge portion and the body portion are also applicable. Details are not described herein again.

According to an embodiment of the present application, further, the second surface 101b of the silicon substrate 101 is a textured surface including a pyramid structure, and may be used as a light-receiving surface. The second-type doped amorphous silicon layer 1022a may or may not include nanocrystalline silicon. When the second-type doped amorphous silicon layer 1022a includes nanocrystalline silicon, a crystalline structure similar to that shown in FIG. 2, FIG. 5A, and FIG. 5B is obtained. Therefore, light utilization on the light-receiving surface is high. In addition, a contact resistance on the non-illuminated surface can be reduced, to improve efficiency of the solar cell.

According to an embodiment of the present application, further, the solar cell of the present application may further include a first transparent conductive layer 103a and a second transparent conductive layer 103b. The first transparent conductive layer 103a is located on a surface, away from the silicon substrate 101, of the first-type doped amorphous silicon layer 1021a. The second transparent conductive layer 103b is located on a surface, away from the silicon substrate 101, of the second-type doped amorphous silicon layer 1022a.

According to an embodiment of the present application, further, the solar cell of the present application may further include a first electrode 104a and a second electrode 104b. The first electrode 104a is located on the first transparent conductive layer 103a, and the second electrode 104b is located on the second transparent conductive layer 103b.

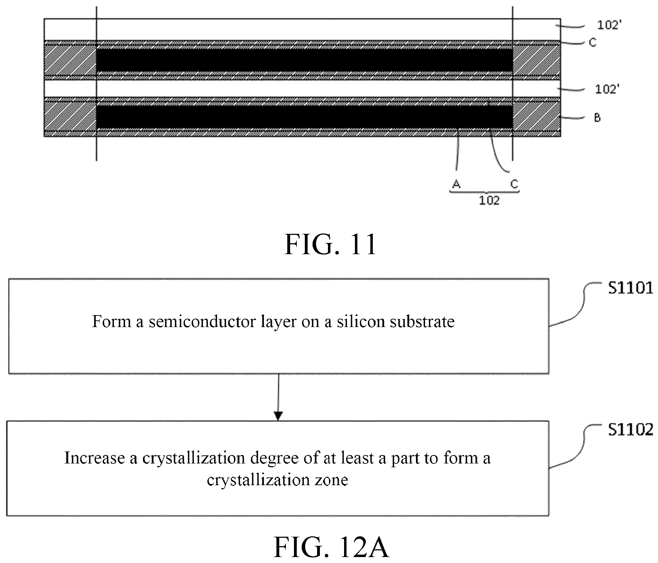

According to an embodiment of the present application, a hybrid HBC solar cell is used as an example to further describe the solar cell of the present application. FIG. 10 is a side view of an overall structure of a solar cell according to still yet another embodiment of the present application. FIG. 11 is a schematic top view of a position relationship between a first-type doped amorphous silicon layer and a second-type doped polycrystalline silicon layer according to still yet another embodiment of the present application. As shown in FIG. 10 and FIG. 11, a silicon substrate 101 includes a first surface 101a and a second surface 101b that are opposite to each other. The first surface 101a includes a first region 101a' and a second region 101a" that are spaced apart. The first region 101a' is a polished region with a pyramid base structure. A first semiconductor layer 102 is located in the first region 101a' of the silicon substrate 101. The solar cell further includes a second semiconductor layer 102' located in the second region 101a" of the silicon substrate 101. A conduction type of the second semiconductor layer 102' is different from that of the first semiconductor layer 102.

The first semiconductor layer 102 extends to be above the second semiconductor layer 102', to overlap with the second semiconductor layer 102' to form an overlapping part C. A first semiconductor layer 102 at the overlapping part C belongs to the edge portion B. Herein, a position corresponding to the overlapping part C is a position indicated by a rectangular box in FIG. 10. The first semiconductor layer 102 at the overlapping part is designed to have a lower crystallization degree compared with a body portion. This helps mitigate electrical leakage between the first semiconductor layer 102 and the second semiconductor layer 102', and can further increase a reverse conduction voltage, to provide a large reverse voltage for preventing hot spots.

According to an embodiment of the present application, as shown in FIG. 11, the first semiconductor layer 102 and the second semiconductor layer 102' are strip-shaped parts separately extending along a first direction, and are alternately distributed along a second direction perpendicular to the first direction. The first semiconductor layer 102 may further include an edge portion B distributed on two side edges of the first semiconductor 102 along the first direction. The edge portion B, together with the overlapping part C, forms an annular shape surrounding a periphery of the body portion A.

According to an embodiment of the present application, along a direction from the body portion A to the edge portion B, a width of the edge portion is less than or equal to 500 µm. In this arrangement, the width of the edge portion is shortened as much as possible to enlarge a region of the body portion, to reduce a contact resistance and improve a current collection capability. In addition, in an embodiment, the width of the edge portion is greater than or equal to 100 µm, to ensure that a laser does not affect performance of other layers due to a precision issue, for example, the laser is irradiated to a boundary position of the second semiconductor layer.

According to an embodiment of the present application, when the first region 101a' of the silicon substrate 101 is a textured region including a pyramid structure, the foregoing structural setting of the overlapping part is also applicable. Details are not described herein again.

According to an embodiment of the present application, the solar cell of the present application may further include a transparent conductive layer 103. The transparent conductive layer 103 is located on a surface of a first-type doped amorphous silicon layer 1021a that faces away from the first region 101a' of the silicon substrate 101, and a surface of a second-type doped polycrystalline silicon layer 1023 that faces away from the second region 101a" of the silicon substrate 101. It can be understood that the transparent conductive layer 103 herein has a patterned layer structure.

According to an embodiment of the present application, for example, as shown in FIG. 10 and FIG. 11, a first structural region 102a of the first semiconductor layer 102 includes the first-type doped amorphous silicon layer 1021a, and the second semiconductor layer 102' includes the second-type doped polycrystalline silicon layer 1023. The solar cell of the present application further includes a first intrinsic amorphous silicon layer 1021b, a tunneling oxide layer 105, and an electrode 104. The first intrinsic amorphous silicon layer 1021b is located between the silicon substrate 101 and the first-type doped amorphous silicon layer 1021a. The tunneling oxide layer 105 is located between the silicon substrate 101 and the second-type doped polycrystalline silicon layer 1023. The electrode 104 is located on the transparent conductive layer 103 The first intrinsic amorphous silicon layer 1021b, the first-type doped amorphous silicon layer 1021a, and the silicon substrate 101 form a heterojunction. The tunneling oxide layer 105 and the second-type doped polycrystalline silicon layer 1023 form a tunneling oxide passivated structure.

According to an embodiment of the present application, a material of the transparent conductive layer 103 is not particularly limited. For example, the transparent conductive layer 103 may be made of a transparent conductive oxide (TCO), and specifically, for example, may be made of an indium tin oxide (ITO), a tungsten-doped tin oxide (VTTO), a tungsten-doped indium oxide (IWO), a molybdenum-doped indium oxide (IMO), or a tin oxide fluoride (TOF), but is not limited thereto. The transparent conductive layer 103 is conformally formed on the first semiconductor layer 102 and covers a porous structure of the first semiconductor layer 102, to form close contact with the first semiconductor layer 102.

According to an embodiment of the present application, the first intrinsic amorphous silicon layer 1021b extends to be above the second-type doped polycrystalline silicon layer 1023. In this case, the first intrinsic amorphous silicon layer 1021b located between the first-type doped amorphous silicon layer 1021a and the second-type doped polycrystalline silicon layer 1023 is used for insulation. A smaller thickness of the first intrinsic amorphous silicon layer 1021b indicates a smaller wall thickness of the first intrinsic amorphous silicon layer 1021b along a lateral direction, leading to poorer insulation effect, a larger leakage current, and lower efficiency of the solar cell. The "lateral direction" is a direction from a side wall of the first-type doped amorphous silicon layer 1021a to a side wall of the second-type doped polycrystalline silicon layer 1023.

According to some embodiments of the present application, a manufacturing method for a social cell is further provided. FIG. 12A is a schematic diagram of a manufacturing process of a solar cell according to an embodiment of the present application. As shown in FIG. 12A, the manufacturing method for a social cell in this embodiment of this application mainly includes operation S1101 and operation S1102.

Operation S1101: Form a semiconductor layer on a first surface of a silicon substrate. A meaning of the "semiconductor layer" is the same as that described above. In addition, an example in which the semiconductor layer is an amorphous silicon layer is used below for further description.

Operation S1102: Process the semiconductor layer by using a first laser, to increase a crystallization degree of at least a part of the semiconductor layer to form a crystallization zone.

A semiconductor layer located in the crystallization zone including a second structural region and a first structural region. A crystallization degree of the first structural region is higher than a crystallization degree of the second structural region. The second structural region is closer to the first surface than the first structural region.

According to an embodiment of the present application, in the present application, an amorphous silicon layer is processed by using a laser, so that a part of the amorphous silicon layer forms a porous structure or is crystallized. Only an operation of applying the laser to the amorphous silicon layer needs to be added based on an original process for a solar cell. This has an advantage of simple operations.

According to an embodiment of the present application, the semiconductor layer is crystallized, so that a thickness of an intrinsic silicon layer in the semiconductor layer increases to 8 nm to 20 nm, and for example, may be 8 nm, 10 nm, 13 nm, 15 nm, 18 nm, or 20 nm.

According to an embodiment of the present application, a wavelength of the first laser ranges from 325 nm to 532 nm, and for example, may be 325 nm, 350 nm, 400 nm, 450 nm, 500 nm, or 532 nm. A pulse width of the first laser ranges from an order of magnitude of picoseconds to an order of magnitude of nanoseconds. Energy density of the first laser ranges from 200 mJ/cm² to 6000 mJ/cm², and for example, may be 200 mJ/cm², 500 mJ/cm², 1000 mJ/cm², 2000 mJ/cm², 3000 mJ/cm², 4000 mJ/cm², 5000 mJ/cm², or 6000mJ/cm². A laser overlap rate ranges from 60% to 95%, and for example, may be 60%, 65%, 70%, 75%, 80%, 85%, 90%, or 95%.

In some exemplary embodiments, a laser condition of a used laser may be separately adjusted to a laser condition 1 to a laser condition 4. Specific parameters of the laser condition 1 to the laser condition 4 are shown in Table 1.

**Table 1**

| Laser condition | Wavelength/nm | Pulse width/ns | Energy density/mJ/cm² | Overlap rate |
|---|---|---|---|---|
| 1 | 532 | 20 | 400 | 95% |
| 2 | 532 | 10 | 300 | 95% |
| 3 | 532 | 20 | 200 | 80% |
| 4 | 532 | 20 | 100 | 75% |

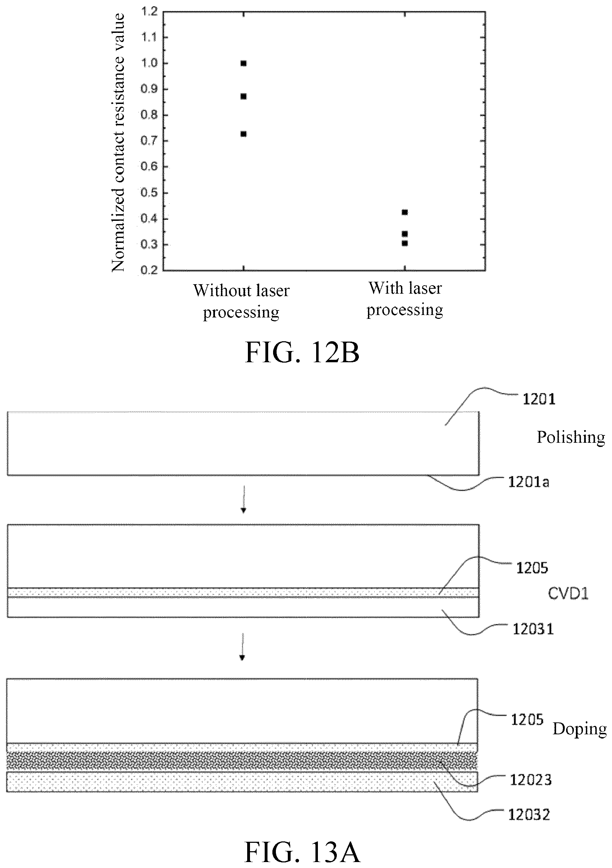

Current-voltage tests are performed to test a contact resistance of an amorphous silicon layer to which no laser is applied and a contact resistance of an amorphous silicon layer to which a first laser under a laser condition 1 to a laser condition 4 is separately applied. Specifically, tests are performed on double-side-symmetrical p-a-Si, i-a-Si, p-a-Si, a TCO layer, and an electrode structure, and it is found that contact resistances of amorphous silicon layers processed by using the first laser under different laser conditions are significantly reduced. FIG. 12B is a diagram of a contact resistance test result of an amorphous silicon layer to which the first laser is applied, that is covered by a TCO layer, and on which a metal electrode is formed according to an embodiment of the present application. In an embodiment, FIG. 12B shows a contact resistance of an amorphous silicon layer to which the first laser under the laser condition 1 is applied. A result is shown in FIG. 12B. Compared with a contact resistance of an amorphous silicon layer without laser processing, a contact resistance of an amorphous silicon layer processed by using the first laser under the laser condition 1 is significantly reduced. This is because appearance of a crystalline structure is observed in the amorphous silicon layer processed by using the first laser.

According to an embodiment of the present application, along a direction parallel to the first surface, the semiconductor layer includes a body portion and an edge portion adjacent to a periphery of the body portion; and operation S1102 specifically includes: irradiating the body portion of the semiconductor layer by using the first laser, to cause a crystallization degree of the body portion to be higher than a crystallization degree of the edge portion, and cause a crystallization degree of the first structural region in the body portion to be higher than a crystallization degree of the second structural region.

According to an embodiment of the present application, the semiconductor layer is made of amorphous silicon, and operation S1102 specifically includes: processing the semiconductor layer by using the first laser, to cause a part of amorphous silicon of the semiconductor layer to be crystallized, to form nanocrystalline silicon in the crystallization zone of the semiconductor layer.

According to an embodiment of the present application, the manufacturing method of the present application further includes operation S1103: Forming a transparent conductive layer on a surface, away from the silicon substrate, of the laser-processed semiconductor layer.

According to the embodiments of the present application, to further understand an overall manufacturing process of the solar cell of the present application, a specific method for manufacturing a hybrid HBC solar cell shown in FIG. 10 is used as an example for description. FIG. 13A to FIG. 13E are schematic diagrams of a manufacturing process of a solar cell according to a further embodiment of the present application. As shown in FIG. 13A to FIG. 13E, the manufacturing method for a social cell in the embodiments of the present invention includes operation S1201 to operation S1205.

Operation S1201: Form a tunneling oxide layer 1205 and a second-type doped polycrystalline silicon layer 12023 on a first surface 1201a of a silicon substrate 1201.

Operation S1202: Pattern the tunneling oxide layer 1205 and the second-type doped polycrystalline silicon layer 12023, and retain a tunneling oxide layer 1205 and a second-type doped polycrystalline silicon layer 12023 in a second region 1201a" of the first surface 1201a.

Operation S1203: Texture and polish regions of the first surface 1201a other than the second region 1201a" to obtain a polished surface including a pyramid base structure.

Operation S1204: Sequentially form an intrinsic amorphous silicon layer 12021 and a first-type doped amorphous silicon layer 12022 on the polished surface, and process the first-type doped amorphous silicon layer 12022 by using a first laser. In an embodiment, a boundary of processing does not reach a boundary of the adjacent second-type doped polycrystalline silicon layer 12023, and there is a specific distance between a boundary of the first-type doped amorphous silicon layer 12022 processed by using the first laser and the boundary of the second-type doped polycrystalline silicon layer 12023. For example, the distance may range from 50 µm to 200 µm.

Operation S1205: Prepare a pattered transparent conductive layer 1203 and an electrode 1204 on a surface of the laser-processed first-type doped amorphous silicon layer 1203a and a surface of the second-type doped polycrystalline silicon layer 12023.

According to an embodiment of the present application, as shown in FIG. 13A, operation S1201 may specifically include: (1) Polishing: Double-side polishing is performed on the silicon substrate 1201, to make a surface of the silicon substrate 1201 flat and smooth. (2) First chemical vapor deposition (CVD 1): The tunneling oxide layer 1205 and a polycrystalline silicon or amorphous silicon layer 12031 are sequentially deposited on the first surface 1201a of the double-side-polished silicon substrate 1201 by using a CVD method. A deposition condition is not key to the present application, and is not described in detail herein. (3) Doping: The polycrystalline silicon or amorphous silicon layer 12031 is converted into the second-type doped polycrystalline silicon layer 12023 through a diffusion process. A diffusion condition is not key to the present application, and is not described in detail herein.

It can be understood that, different doping types and diffusion processes may form different doping sources 12032 on a surface of the second-type doped polycrystalline silicon layer 12023. For example, a phosphorus diffusion process forms phosphosilicate glass on the surface of the second-type doped polycrystalline silicon layer 12023, and a boron diffusion process forms borosilicate glass on the surface of the second-type doped polycrystalline silicon layer 12023.

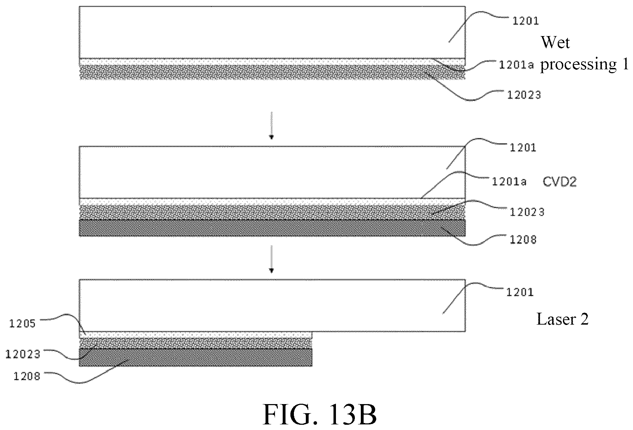

According to an embodiment of the present application, as shown in FIG. 13B, operation S1202 may specifically include:
(1) First wet processing (wet processing 1): The doping source 12032 is removed through wet processing. For example, the phosphosilicate glass or the borosilicate glass may be removed through a pickling process.
(2) Second chemical vapor deposition (CVD 2): A mask layer 1208 is deposited on a surface, away from the silicon substrate 101, of the second-type doped polycrystalline silicon layer 12023 by using a CVD method. For example, a silicon nitride layer may be deposited. A deposition condition is not key to the present application, and is not described in detail herein.
(3) Second laser processing (laser 2): Laser-based film removal is performed on the tunneling oxide layer 1205, the second-type doped polycrystalline silicon layer 12023, and the mask layer 1208 by using a second laser, to remove a tunneling oxide layer 1205 and a second-type doped polycrystalline silicon layer 12023 that are located in regions of the first surface 1201a other than the second region 1201a". A condition of laser-based film removal is not key to the present application, and is not described in detail herein.

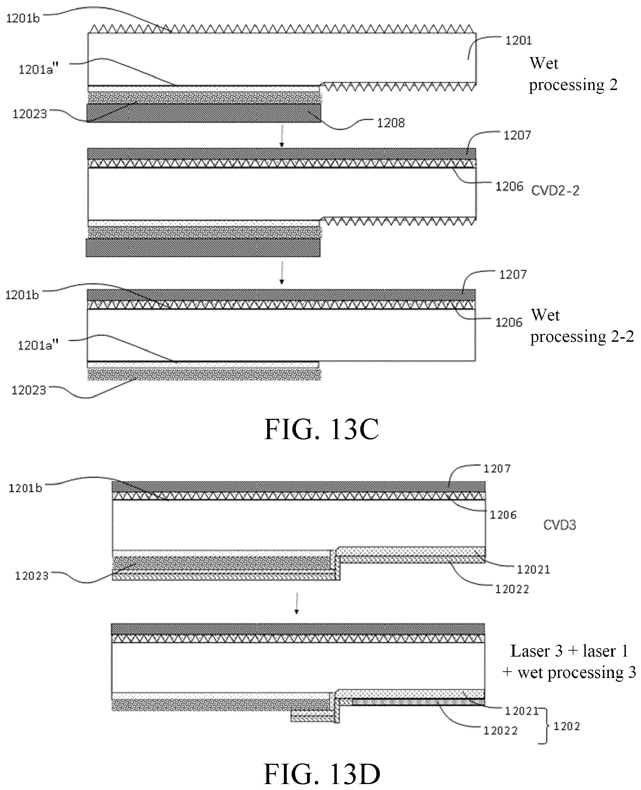

According to an embodiment of the present application, as shown in FIG. 13C, operation S1203 may specifically include:
(1) Second wet processing (wet processing 2): Wet texturing is performed on regions of the first surface 1201a other than the second region 1201a", and a second surface 1201b of the silicon substrate through double-side texturing. For example, wet texturing may be performed by using an alkaline tank device.
(2) Second chemical vapor deposition (CVD 2-2): A passivated and anti-reflective layer is deposited on the wet-textured second surface 1201b of the silicon substrate 1201 by using a CVD method. For example, a third intrinsic amorphous silicon layer 1206 and a silicon nitride layer 1207 are sequentially deposited.
(3) Second wet processing (wet processing 2-2): Alkaline polishing is performed on regions of the first surface 1201a other than the second region 1201a" by using a chain device to obtain a polished surface, and the mask layer on the surface of the second-type doped polycrystalline silicon layer 12023 is removed through pickling by using the chain device.

According to an embodiment of the present application, in another implementation, the polishing operation in operation S1203 may alternatively be omitted, to obtain a textured surface including a pyramid structure. Then an intrinsic amorphous silicon layer 12021 and a first-type doped amorphous silicon layer 12022 are sequentially formed on the textured surface.

According to an embodiment of the present application, as shown in FIG. 13D, operation S1204 may specifically include:
(1) Third chemical vapor deposition (CVD 3): An intrinsic amorphous silicon layer 12021 and a first-type doped amorphous silicon layer 12022 are sequentially deposited on the polished surface of the silicon substrate 1201 and the surface of the second-type doped polycrystalline silicon layer 12023 by using a CVD method. An isolation region may be formed between the first-type doped amorphous silicon layer 12022 and the second-type doped polycrystalline silicon layer 12023 by using the intrinsic amorphous silicon layer 12021, to implement an insulation function.
(2) Laser processing and third wet processing (laser 3 + laser 1 + wet processing 3): First, a part of the intrinsic amorphous silicon layer 12021 and the first-type doped amorphous silicon layer 12022 on the surface of the second-type doped polycrystalline silicon layer 12023 is removed by using a third laser. Overlapping occurs between a retained first-type doped amorphous silicon layer 12022 and the second-type doped polycrystalline silicon layer 12023. The overlapping part can reduce damage to the second-type doped polycrystalline silicon layer 12023 when film removal subsequently performed on a transparent conductive layer in the isolation region. Then, at least a part of a part, other than the overlapping part, of the first-type doped amorphous silicon layer 12022 is processed by using the first laser, to form a crystallization zone on the first-type doped amorphous silicon layer 12022. Then, a silicon oxide formed on a surface of a film layer after the third laser and the first laser are applied is removed through pickling.

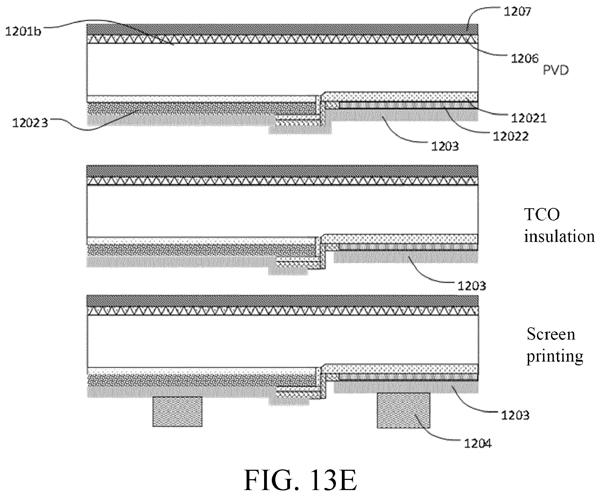

According to an embodiment of the present application, as shown in FIG. 13E, operation S1205 specifically includes: Physical vapor deposition (PVD): A transparent conductive layer 1203 is deposited, by using a PVD method, on an exposed surface of the second-type doped polycrystalline silicon layer 12023 and an exposed surface of the first-type doped amorphous silicon layer 12022 processed by using the first laser. A deposition condition is not key to the present application, and is not described in detail herein.

According to an embodiment of the present application, still as shown in FIG. 13E, after operation S1205, the method may further include:
(1) Insulation processing (TCO insulation): A transparent conductive layer 1203 located at an isolation position between the first-type doped amorphous silicon layer 12022 and the second-type doped polycrystalline silicon layer 12023 is removed, for example, may be removed through laser-based film removal.
(2) Screen printing: An electrode 1204 is prepared on the transparent conductive layer 1203 through screen printing, to obtain a social cell of the structure shown in FIG. 10.

According to the embodiments of the present application, in the solar cell obtained by using the foregoing manufacturing method, a contact resistance with the transparent conductive layer is reduced based on a porous structure and/or a crystalline structure of first-type doped amorphous silicon, so that space is released for thickening the intrinsic amorphous silicon layer. This can achieve a balance between the contact resistance, passivation effect, and a leakage current, to improve efficiency of the solar cell.

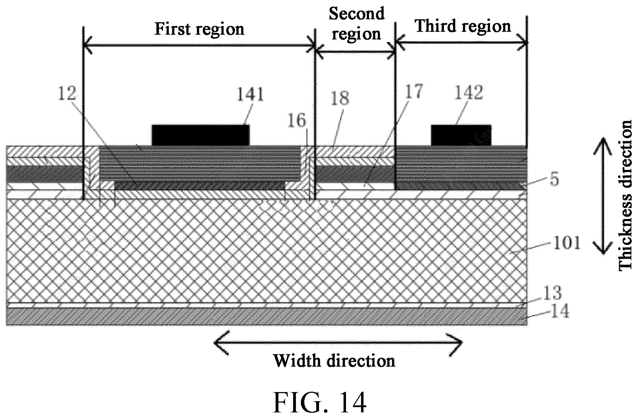

In some other embodiments of the present application, a solar cell is further provided. As shown in FIG. 14, the solar cell includes a silicon substrate 101, and a side surface of the silicon substrate 101 includes a first region, a second region, and a third region that are sequentially adjacent to each other.

In the first region, a first doped layer (namely, a first semiconductor layer 102) and a third electrode 141 are sequentially stacked on the silicon substrate 101. In the third region, a second doped layer (namely, a second semiconductor layer 102') and a fourth electrode 142 are sequentially stacked on the silicon substrate 101. Conductivity of the first doped layer is opposite to conductivity of the second doped layer.

At least one of the first doped layer in the first region and the second doped layer in the third region has a crystallization zone. A projection of the crystallization zone on the silicon substrate 101 at least partially overlaps with a projection of the third electrode 141 on the silicon substrate 101, and/or the projection of the crystallization zone on the silicon substrate 101 at least partially overlaps with a projection of the fourth electrode 142 on the silicon substrate 101.

In addition, the first doped layer and the second doped layer extend to the second region. In the second region, at least a part of the first doped layer is an amorphous zone, and at least a part of the second doped layer is an amorphous zone.

In the social cell provided in this embodiment, because photon-generated carriers perform lateral transfer and diffusion (in a direction perpendicular to a thickness direction of a doped layer) and longitudinal transfer and diffusion (in a direction parallel to a thickness direction of a doped layer) in doped layers of different doping types, in the present application, the second region with high resistivity is arranged between the first doped layer in the first region and the second doped layer in the third region for isolation, so that lateral transfer of carriers can be reduced, and leakage can be reduced. In addition, at least one of the first doped layer in the first region and the second doped layer in the third region has a crystallization zone, and the crystallization zone has good conductivity, facilitating carrier collection. In addition, in the second region, at least a part of the first doped layer is an amorphous zone, and at least a part of the second doped layer is an amorphous zone. The amorphous zone has lower carrier mobility and lower sheet resistance than the crystallization zone, so that a leakage current can be greatly reduced.

The silicon substrate includes a light-receiving surface and a non-illuminated surface that are distributed opposite to each other. The non-illuminated surface of the silicon substrate includes a first region, a second region, and a third region that are sequentially adjacent to each other. The being adjacent herein means that the first region, the second region, and the third region are sequentially connected to each other without overlapping.

All of the silicon substrate, the first doped layer, and the second doped layer have a textured structure. Alternatively, all of the silicon substrate, the first doped layer, and the second doped layer have a smooth surface. Alternatively, the silicon substrate and the first doped layer in the first region have a textured surface, and all functional layers in the third region have a smooth surface. Alternatively, the silicon substrate and the first doped layer in the first region have a smooth surface, and all functional layers in the third region have a textured structure.

In the solar cell shown in FIG. 14, in the first region, the first doped layer includes a first crystallization zone 12 and a first amorphous zone A 16. At least a part on a side, away from the silicon substrate, in the first crystallization zone 12 has crystal. In the third region, the second doped layer includes a second crystallization zone 5. In the second region, at least a side, close to the first region, of the first doped layer is a first amorphous zone B 18; and at least a side, close to the first region, of the second doped layer is a second amorphous zone B 17. A light-entrance-surface passivated layer 13 and an anti-reflective layer 14 are sequentially formed on the light-receiving surface of the silicon substrate.

For a TEM image of the second doped layer in the third region in this embodiment, refer to FIG. 8. It can be learned from FIG. 8 that, in the solar cell in this embodiment, under the action of laser, amorphous silicon on a side, away from a silicon sheet, in the first doped layer is converted into crystalline silicon.

The manufacturing method for a solar cell in this embodiment includes the following steps.

Step 1: Polish and clean a silicon sheet, and texture a light entrance surface.

Step 2: Sequentially deposit a 5-nm intrinsic hydrogenated amorphous silicon passivated layer, a 30-nm amorphous n layer, a 100-nm SiNx layer (with a refractive index of 2.5), and a 30-nm laser absorbing layer on a rear surface of the solar cell through PECVD.

Step 3: Remove a laser absorbing layer in a first region by using a laser, to form a laser opening and expose a SiNx layer.

Step 4: Perform wet processing: Use hydrofluoric acid with a concentration of 10% to remove the SiNx layer in the laser opening, to expose an amorphous n layer; and use potassium hydroxide with a concentration of 10% to remove the exposed amorphous n layer, an intrinsic hydrogenated amorphous silicon passivated layer below the exposed amorphous n layer, and a laser absorbing layer in a second region and a third region, to expose a silicon sheet in the first region and a silicon nitride layer in the second region and the third region.

Step 5: On the rear surface of the solar cell, sequentially deposit a 5-nm intrinsic hydrogenated amorphous silicon passivated layer and a 30-nm amorphous p layer on the silicon sheet in the first region and on the silicon nitride layer in the second region and the third region by using the PECVD technology.

Step 6: Remove an amorphous p layer and an intrinsic hydrogenated amorphous silicon passivated layer in the third region by using a laser (single-spot energy density of the laser is 200 mJ/cm²) to form an opening, to expose a SiNx layer in the third region.

Step 7: Perform wet processing: Use hydrofluoric acid with a concentration of 10% to remove the SiNx layer in the third region.

Step 8: Deposit a light-entrance-surface intrinsic hydrogenated amorphous silicon passivated layer and a SiNx anti-reflective film with a refractive index of 2 and a thickness of 70 nm through PECND.

Step 9: Perform laser crystallization: Crystallize a middle region of an amorphous p layer in the first region into a nanocrystalline p region by using a laser. To be specific, the first region includes both a first nanocrystalline silicon p-doped region and a first amorphous silicon p-doped region. The first amorphous silicon p-doped region surrounds the first nanocrystalline silicon p-doped region. A part at which an amorphous n layer in the third region is stacked with an electrode is crystallized into a nanocrystalline n region.

Step 10: Sequentially deposit a TCO layer and an Ag electrode (a third electrode 141) on a nanocrystalline p layer, and sequentially deposit a TCO layer and an Ag electrode (a fourth electrode 142) on a nanocrystalline n layer.

It should be noted that technical features described in this specification based on a specific embodiment or implementation are not only applicable to the specific embodiment or implementation, but also applicable to other embodiments or implementations.

The foregoing specific embodiments further describe the objectives, technical solutions, and beneficial effects of the present application in detail. It should be appreciated that the foregoing descriptions are merely specific embodiments of the present application, and are not intended to limit the present application. Any modification, equivalent replacement, and improvement made without departing from the spirit and principle of the present application shall fall within the protection scope of the present application.

## Claims

1. A solar cell, the solar cell comprising:
a silicon substrate comprising a first surface and a second surface that are opposite to each other; and
a first semiconductor layer located on the first surface, the first semiconductor layer comprising a second structural region and a first structural region, a crystallization degree of the first structural region being higher than a crystallization degree of the second structural region, the second structural region being closer to the first surface than the first structural region, and the first semiconductor layer comprising at least one of amorphous silicon, nanocrystalline silicon, or microcrystalline silicon.

2. The solar cell according to claim 1, wherein the second structural region comprises a first intrinsic silicon layer with a thickness ranging from 5 nm to 30 nm, for example, 8 nm to 20 nm.

3. The solar cell according to claim 1, wherein a material of the second structural region comprises intrinsic amorphous silicon, and a material of the first structural region comprises amorphous silicon and nanocrystalline silicon.

4. The solar cell according to claim 1, wherein a material of the first structural region comprises amorphous silicon and nanocrystalline silicon with a grain size ranging from 5 nm to 25 nm.

5. The solar cell according to claim 1, wherein the first semiconductor layer comprises a plurality of grains, a maximum size of the plurality of grains being less than a thickness of the first semiconductor layer.

6. The solar cell according to claim 1, wherein the solar cell further comprises a transparent conductive layer located on a surface, away from the silicon substrate, of the first semiconductor layer, the first structural region being covered by the transparent conductive layer.

7. The solar cell according to claim 1, wherein along a direction parallel to the first surface, the first semiconductor layer comprises a body portion and an edge portion adjacent to a periphery of the body portion, a crystallization degree of the body portion being higher than a crystallization degree of the edge portion.

8. The solar cell according to claim 7, wherein the first semiconductor layer covers the first surface entirely, and the edge portion is in an annular shape surrounding the body portion.

9. The solar cell according to claim 7, wherein the first surface of the silicon substrate comprises a first region and a second region that are spaced apart, the first semiconductor layer being located in the first region; and
the solar cell further comprises a second semiconductor layer located in the second region, a conduction type of the second semiconductor layer being different from that of the first semiconductor layer,
the first semiconductor layer being located in the first region and extending to the second semiconductor layer to overlap with the second semiconductor layer to form an overlapping part, a first semiconductor layer in the overlapping part belonging to the edge portion.

10. The solar cell according to any one of claims 7 to 9, wherein along a direction from the body portion to the edge portion, a width of the edge portion is less than or equal to 500 µm.

11. The solar cell according to any one of claims 1 to 6, wherein the first surface of the silicon substrate has a polished region comprising a pyramid base structure,
the first semiconductor layer being located in the polished region, and the first semiconductor layer having a porous structure.

12. The solar cell according to claim 11, wherein the first structural region has a first porous structure, and the second structural region has a second porous structure, a pore size of the second porous structure being smaller than a pore size of the first porous structure.

13. The solar cell according to claim 12, wherein the first porous structure has a plurality of first pores arranged in a run-through manner, the second porous structure comprises a plurality of second pores, and the plurality of second pores are exposed from the plurality of first pores.

14. The solar cell according to claim 12, wherein the pore size of the first porous structure is less than or equal to 1 µm, and the pore size of the second porous structure is less than or equal to 300 nm.

15. The solar cell according to claim 11, wherein the first structural region has a porous structure, and the second structural region has a non-porous structure.

16. The solar cell according to any one of claims 1 to 6, wherein the first surface of the silicon substrate has a textured region comprising a plurality of pyramid structures, and along a direction away from the first surface, each of the pyramid structures comprises a pyramid base portion and a pyramid tip portion,
both the first structural region and the second structural region being located on the pyramid tip portion, and the crystallization degree of the second structural region being greater than a crystallization degree of a first semiconductor layer located on the pyramid base portion.

17. The solar cell according to claim 16, wherein a first semiconductor layer located on the pyramid structure has a non-porous structure and has a side surface extending from top to bottom,
along an extension direction of the side surface, a ratio of a maximum extension length, on the side surface, of a first semiconductor layer located on the pyramid tip portion to a length of the side surface being less than or equal to 0.3.

18. The solar cell according to claim 16, wherein a first semiconductor layer located on the pyramid tip portion is partially of a porous structure.

19. The solar cell according to claim 18, wherein at least one pore comprised in the porous structure is a blind via that does not penetrate through the first semiconductor layer, and/or a pore size of at least one pore comprised in the porous structure is less than 100 nm.

20. The solar cell according to claim 18, wherein a first semiconductor layer located on the pyramid structure has a side surface extending from the pyramid tip portion to the pyramid bottom,
along an extension direction of the side surface, a ratio of a distribution length of the porous structure on the side surface to a length of the side surface is less than or equal to 0.5.

21. The solar cell according to claim 18, wherein a thickness of a part, without the porous structure, of the first semiconductor layer is greater than or equal to 10 nm; and/or the thickness of the part, without the porous structure, of the first semiconductor layer is less than or equal to 45 nm.

22. The solar cell according to claim 1, wherein a crystalline volume fraction of the second structural region is greater than or equal to 10%, and/or a difference between the crystalline volume fraction of the second structural region and a crystalline volume fraction of the first structural region is less than or equal to 10%.

23. The solar cell according to claim 1, wherein the solar cell further comprises a second semiconductor layer located on the second surface, the second semiconductor layer comprising a fourth structural region and a third structural region, a crystallization degree of the third structural region being higher than a crystallization degree of the fourth structural region, the fourth structural region being closer to the second surface than the third structural region, and the second semiconductor layer comprising at least one of amorphous silicon, nanocrystalline silicon, or microcrystalline silicon.

24. A manufacturing method for a solar cell, the manufacturing method comprising:
forming a semiconductor layer on a first surface of a silicon substrate, a material of the semiconductor layer comprising at least one of amorphous silicon, nanocrystalline silicon, or microcrystalline silicon; and
processing the semiconductor layer by using a first laser, to increase a crystallization degree of at least a part of the semiconductor layer to form a crystallization zone,
a semiconductor layer located in the crystallization zone comprising a second structural region and a first structural region, a crystallization degree of the first structural region being higher than a crystallization degree of the second structural region, and the second structural region being closer to the first surface than the first structural region.

25. The manufacturing method according to claim 24, wherein a wavelength of the first laser ranges from 325 nm to 532 nm, a pulse width of the first laser ranges from an order of magnitude of picoseconds to an order of magnitude of nanoseconds, and energy density of the first laser ranges from 200 mJ/cm² to 6000 mJ/cm².

26. The manufacturing method according to claim 24, wherein along a direction parallel to the first surface, the semiconductor layer comprises a body portion and an edge portion adjacent to a periphery of the body portion; and
the processing the semiconductor layer by using a first laser, to increase a crystallization degree of at least a part of the semiconductor layer to form a crystallization zone comprises:
irradiating the body portion of the semiconductor layer by using the first laser, to cause a crystallization degree of the body portion to be higher than a crystallization degree of the edge portion, and cause a crystallization degree of the first structural region in the body portion to be higher than a crystallization degree of the second structural region.

27. The manufacturing method according to claim 24, wherein the semiconductor layer is made of amorphous silicon, and the processing the semiconductor layer by using a first laser, to increase a crystallization degree of at least a part of the semiconductor layer to form a crystallization zone comprises:
processing the semiconductor layer by using the first laser, to cause a part of amorphous silicon of the semiconductor layer to be crystallized, to form nanocrystalline silicon in the crystallization zone of the semiconductor layer.
